# EUROPEAN PATENT APPLICATION

(11) **EP 2 615 466 A1**
(43) Date of publication of application: **17.07.2013**
(21) Application number: 10856996.3
(22) Date of filing: 10.09.2010
(51) Int. Cl.: G01R 31/00

(54) **OVERVOLTAGE DETECTING DEVICE FOR ENERGY STORAGE MODULE**

(71) Applicant: Mitsubishi Electric Corporation, Tokyo 100-8310 (JP)
(72) Inventor: ISHIKAWA, Junichiro, Tokyo 100-8310 (JP)
(74) Representative: HOFFMANN EITLE
(86) International application number: PCT/JP2010/065609
(87) International publication number: WO 2012/032651

(57) **Abstract**

Provided is an overvoltage detecting device for an energy storage module, including a plurality of overvoltage detecting sections, each of which is connected in parallel to each of a plurality of storage cells, is supplied with power from an external power supply, and monitors an interterminal voltage of the each of the plurality of storage cells. The plurality of overvoltage detecting sections output an ON signal for indicating that the storage cells are normal when the interterminal voltages of the plurality of storage cells are a predetermined reference voltage or lower. The plurality of overvoltage detecting sections output an OFF signal when the interterminal voltages of the plurality of storage cells exceed the reference voltage.

## Description

### Technical Field

The present invention relates to an overvoltage detecting device for an energy storage module to be disposed in the energy storage module including a plurality of storage cells formed of electric double-layer capacitors or lithium-ion capacitors.

### Background Art

In general, an electric double-layer capacitor module as an energy storage module includes a plurality of storage cells (capacitor cells) connected in series so as to obtain a desired energy amount and realize a voltage that can be used easily by a connected circuit. Note that, the plurality of storage cells are connected in series in this way because an allowable voltage of a single storage cell is as low as approximately 3 V.

When the storage cells are connected in series, if the module is charged or discharged in a state where the balance of leakage current among the storage cells is lost or the capacitance is varied among the storage cells, an interterminal voltage of each storage cell may be unbalanced and may exceed the allowable voltage of a single storage cell. When the voltage applied to the single storage cell exceeds the allowable voltage in this way, the performance may be degraded in a relatively short time so that the storage cell may become an abnormal state. Therefore, it is necessary to prevent an overvoltage from being applied to each storage cell.

Contrary to this, in a conventional device, an abnormality detection circuit is connected in parallel to a capacitor unit (unit in which a plurality of storage cells are connected in parallel), and the abnormality detection circuit can detect that the interterminal voltage of the capacitor unit has reached a reference voltage or higher (for example, see Patent Literature 1). Specifically, when an overvoltage is applied to one of the storage cells, a photocoupler of the abnormality detection circuit becomes a conductive state so that a control portion in a subsequent stage of the abnormality detection circuit is informed of the abnormal state of the capacitor unit.

### Citation List

### Patent Literature

[PTL 1] JP 2009-244171 A

### Summary of Invention

### Technical Problem

The conventional device described above adopts a configuration that is conductive in an abnormal state. Therefore, when there occurs a malfunction of the wirings such as breaking of wire or removal of a connector in wirings in a subsequent stage of the photocoupler, for example, the malfunction of the wirings cannot be detected. In addition, in this case, when an overvoltage is applied to the storage cell, generation of the overvoltage cannot be informed to the control portion.

In addition to this, the conventional device has another problem as follows. Because each element of the abnormality detection circuit operates first when the capacitor module is in an abnormal state, even if a malfunction occurs in an element itself of the abnormality detection circuit, the malfunction is hardly detected. Therefore, the conventional device described above does not have sufficient reliability, and it is desired to improve the reliability in order to apply the device to an elevator or an electric vehicle, for example.

Here, in the conventional device, in the case of adopting a configuration in which a signal is generated actively in a normal state of the storage cell (a configuration being conductive in a normal state and being nonconductive in an abnormal state), the abnormality detection circuit operates by being supplied with power from the storage cell. Therefore, when the interterminal voltage of the storage cell becomes lower than a minimum operating voltage of the abnormality detection circuit (even only the photocoupler needs 1.1 V), the malfunction detection cannot be performed. In this way, it is hard for the conventional device to realize a circuit that operates even when the interterminal voltage of the storage cell is low.

The present invention has been made to solve the above-mentioned problems, and it is an object of the present invention to provide an overvoltage detecting device for an energy storage module which is capable of improving reliability, and stably detecting an overvoltage of a storage cell regardless of an interterminal voltage of the storage cell.

### Solution to Problem

According to the present invention, there is provided an overvoltage detecting device for an energy storage module to be disposed in the energy storage module including a plurality of storage cells connected in series, each of which includes an electric double-layer capacitor or a lithium-ion capacitor, the overvoltage detecting device including a plurality of overvoltage detecting portions, each of which is connected in parallel to each of the plurality of storage cells, is supplied with power from an external power supply, monitors an interterminal voltage of the each of the plurality of storage cells, outputs an ON signal for indicating that the each of the plurality of storage cells is normal when the interterminal voltage is a predetermined reference voltage or lower, and outputs an OFF signal when the interterminal voltage of the each of the plurality of storage cells exceeds the predetermined reference voltage.

### Brief Description of Drawings

[FIG. 1] A circuit diagram illustrating an energy storage module according to a first embodiment of the present invention.
[FIG. 2] A circuit diagram illustrating a flow of current in an operating voltage generating portion illustrated in FIG. 1.
[FIG. 3] A waveform diagram illustrating an operation of the operating voltage generating portion illustrated in FIG. 1.

### Description of Embodiments

An embodiment of the present invention is hereinafter described with reference to the drawings.

### First Embodiment

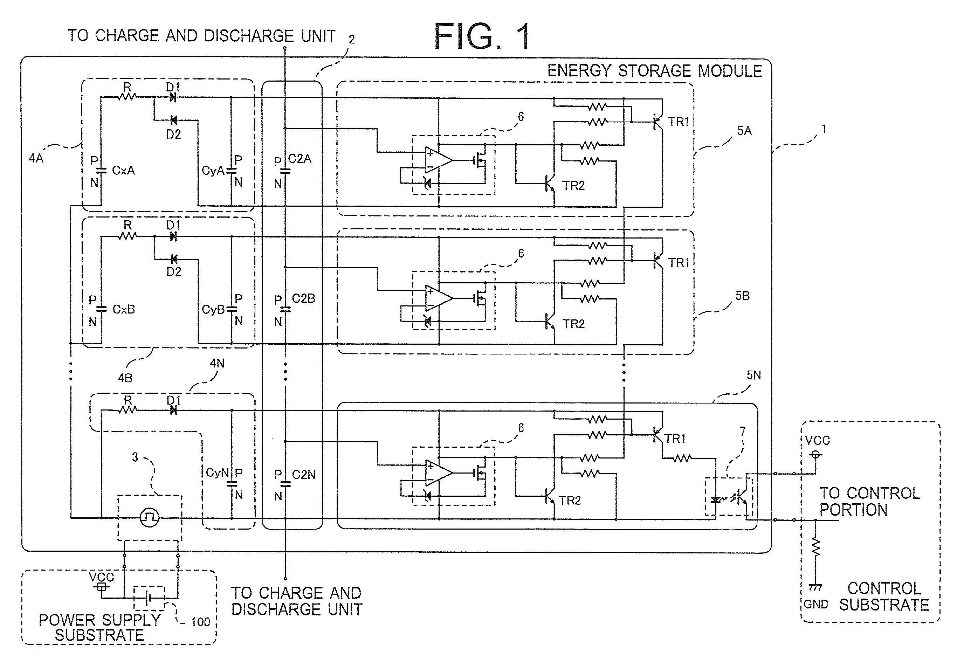

FIG. 1 is a circuit diagram illustrating an energy storage module according to a first embodiment of the present invention.

In FIG. 1, an energy storage module 1 includes a plurality of storage cells C2A to C2N, a rectangular wave oscillating portion 3 as an AC voltage source, a plurality of operating voltage generating portions 4A to 4N, and a plurality of overvoltage detecting sections (malfunction detection portions) 5A to 5N.

As used herein, reference symbols A to N of the plurality of storage cells C2A to C2N, the plurality of operating voltage generating portions 4A to 4N, and the plurality of overvoltage detecting sections 5A to 5N indicate a connection system. In addition, reference symbol N is an arbitrary integer. Further, as used herein, among the plurality of storage cells C2A to C2N, the plurality of operating voltage generating portions 4A to 4N, and the plurality of overvoltage detecting sections 5A to 5N, those that do not specify the connection system are referred to also as a storage cell C2, an operating voltage generating portion 4, and an overvoltage detecting section 5, respectively.

The storage cell C2 is an electric double-layer capacitor or a lithium-ion capacitor. In addition, the plurality of storage cells C2A to C2N are connected in series so as to constitute an energy storage unit 2 as a whole. The energy storage unit 2 is connected to a charge and discharge unit (charge and discharge circuit). The energy storage unit 2 stores power supplied from the charge and discharge unit, and supplies the stored power to the charge and discharge unit. In addition, when the energy storage unit 2 stores power, the voltage from the charge and discharge unit is substantially uniformly divided and applied to each of the plurality of storage cells C2A to C2N in the energy storage unit 2.

The rectangular wave oscillating portion 3 is connected via a connector and a cable to an external power supply 100 disposed on an external power supply substrate of the energy storage module 1. In addition, the rectangular wave oscillating portion 3 is connected to the storage cell C2N disposed at the last stage. Further, the rectangular wave oscillating portion 3 is supplied with power from the external power supply 100 and generates a rectangular wave voltage (pulse wave) as an AC voltage. The amplitude of this rectangular wave voltage is 5 V, for example. Each of the plurality of operating voltage generating portions 4A to 4N is connected in parallel to each of the plurality of storage cells C2A to C2N.

In addition, the operating voltage generating portion 4 is supplied with the rectangular wave voltage from the rectangular wave oscillating portion 3. Further, the operating voltage generating portion 4 rectifies the rectangular wave voltage from the rectangular wave oscillating portion 3 and supplies the rectified voltage as the operating voltage to the overvoltage detecting section 5.

Further, the operating voltage generating portion 4 except the operating voltage generating portion 4N includes a first capacitor Cx for level shift (CxA and CxB in FIG. 1), a resistor R, a first rectifying diode D1, a second diode D2 for setting a level shift amount, and a second smoothing capacitor Cy (CyA and CyB in FIG. 1). Note that, the first capacitor Cx constitutes a level shift portion, the first diode D1 constitutes a rectifying portion, and the second capacitor Cy constitutes a smoothing portion.

A negative electrode of the first capacitor Cx is connected in series to the rectangular wave oscillating portion 3. One end of the resistor R is connected to a positive electrode of the first capacitor Cx. The first capacitor Cx and the resistor R constitute a serial connection unit. An anode terminal of the first diode D1 is connected to the other end of the resistor R. A cathode terminal of the first diode D1 is connected to a positive electrode of the second capacitor Cy.

A cathode of the second diode D2 is connected to an anode of the first diode D1. An anode of the second diode D2 is connected to a negative electrode of the storage cell C2 and a negative electrode of the second capacitor Cy. Both ends of the second capacitor Cy are connected to a power supply input of the overvoltage detecting section 5.

The operating voltage generating portion 4N includes the resistor R, the rectifying diode D1, and a smoothing capacitor CyN, while the capacitor Cx and the diode D2 are eliminated. In other words, the operating voltage generating portion 4N is simplified compared with the operating voltage generating portions 4A and 4B. In this way, the capacitor Cx and the diode D2 are eliminated in the operating voltage generating portion 4N because the level shift is not necessary in the operating voltage generating portion 4N.

Note that, it is possible to use the capacitor Cx and the diode D2 without being eliminated in the operating voltage generating portion 4N similarly to the operating voltage generating portions 4A and 4B. In this case, the same wiring pattern can be formed on the circuit substrate of the operating voltage generating portion 4N and the circuit substrates of the other operating voltage generating portions 4 than the operating voltage generating portion 4N so that the manufacturing process can be simplified.

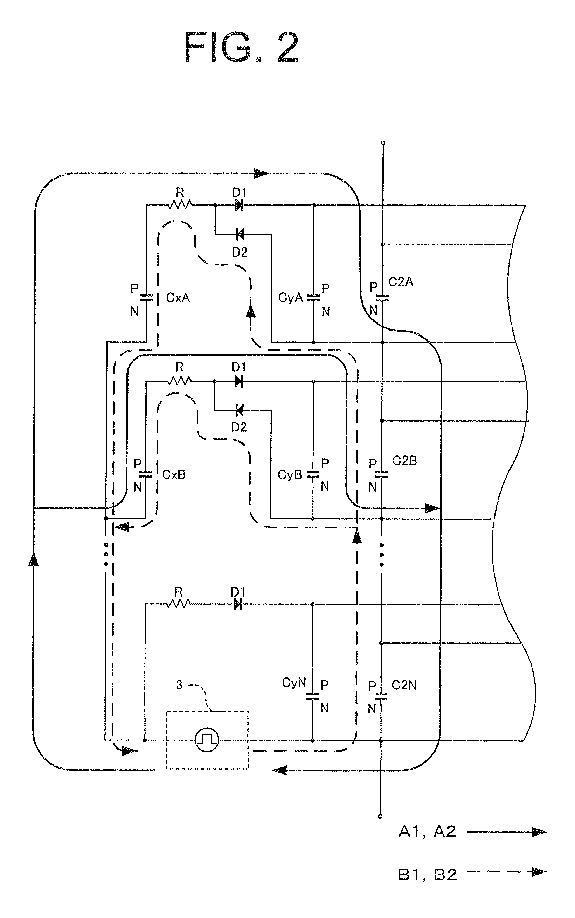

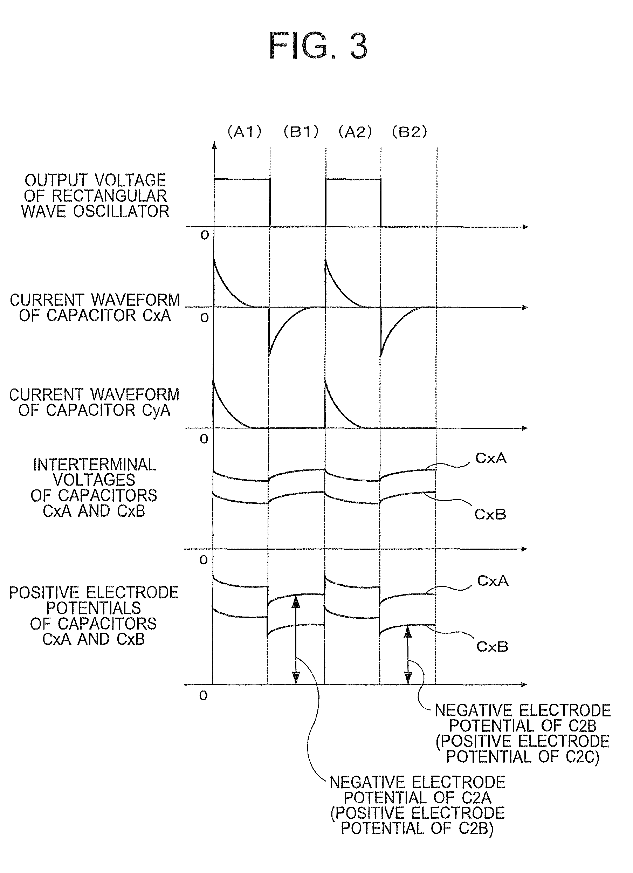

Next, an operation of the operating voltage generating portion 4 is described. FIG. 2 is a circuit diagram illustrating a flow of current in the operating voltage generating portion 4 illustrated in FIG. 1. FIG. 3 is a waveform diagram illustrating the operation of the operating voltage generating portion 4 illustrated in FIG. 1. Note that, A1, B1, A2, and B2 in parentheses in FIG. 3 respectively correspond to arrows A1, B1, A2, and B2 indicating directions of current in FIG. 2.

As illustrated in FIG. 3, the current of the first capacitor CxA varies in accordance with both a rising edge and a falling edge of the rectangular wave. The current of the second capacitor CyA varies in accordance with only the rising edge of the rectangular wave because the rectangular wave is rectified by the first diode D1. The rectangular wave is smoothed by the first capacitor CyA, and a DC voltage of 5 V is applied as the operating voltage to the overvoltage detecting section 5. The operation of the first capacitor CyB is the same as that of the first capacitor CyA. Because each of the first capacitors CxA and CxB is charged and discharged in accordance with the rising and falling edges of the rectangular wave, the interterminal voltages of the first capacitors CxA and CxB vary slightly.

Here, when the rectangular wave is L level (0 V), a potential of the positive electrode of the first capacitor CxA is charged to the potential corresponding to the potential of the negative electrode of the storage cell C2A (the potential of the positive electrode of the storage cell C2B). On the other hand, when the rectangular wave is H level (5 V), a potential of the positive electrode of the first capacitor CxA is a potential obtained by adding the amplitude of the rectangular wave voltage to the potential of the negative electrode of the storage cell C2A. In contrast, a potential of the negative electrode of the first capacitor CxA is the potential corresponding to L level of the rectangular wave voltage when the rectangular wave is L level, and is the potential corresponding to H level of the rectangular wave voltage when the rectangular wave is H level.

Similarly, when the rectangular wave is L level, a potential of the positive electrode of the first capacitor CxB is charged to the potential corresponding to the potential of the negative electrode of the storage cell C2B (the potential of the positive electrode of the storage cell C2C disposed below the storage cell C2B). When the rectangular wave is H level, the potential of the positive electrode of the first capacitor CxB is a potential obtained by adding the amplitude of the rectangular wave voltage to the potential of the negative electrode of the storage cell C2B. In contrast, a potential of the negative electrode of the first capacitor CxB is the potential corresponding to L level of the rectangular wave voltage when the rectangular wave is L level, and is the potential corresponding to H level of the rectangular wave voltage when the rectangular wave is H level.

Therefore, the first capacitor CxA is level-shifted by sequentially adding potential differences of the negative electrode of the storage cell C2A and the negative electrode of the storage cell C2N to the rectangular wave voltage with reference to the connection node between the negative electrode of the storage cell C2N disposed at the final stage and the rectangular wave oscillating portion 3. In other words, the first capacitor CxA separates a high voltage region of an electric circuit on the storage cell C2A side from an electric circuit on the rectangular wave oscillating portion 3 side. Similarly, the first capacitor CxB is level-shifted by sequentially adding potential differences of the negative electrode of the storage cell C2B and the negative electrode of the storage cell C2N to the rectangular wave voltage with reference to the connection node between the negative electrode of the storage cell C2N and the rectangular wave oscillating portion 3.

In this way, the first capacitor Cx is level-shifted by adding the potential difference between the negative electrode of the storage cell C2 disposed in the same connection system as the first capacitor Cx and the negative electrode of the storage cell C2N to the rectangular wave voltage with reference to the connection node between the negative electrode of the storage cell C2N disposed at the lowermost among the plurality of storage cells C2A to C2N and the rectangular wave oscillating portion 3.

Next, the configuration and operation of the overvoltage detecting section 5 are described. The overvoltage detecting section 5 includes a comparator 6, a first transistor TR1, a second transistor TR2, and a plurality of resistors for voltage dividing. Here, among the plurality of overvoltage detecting sections 5A to 5N, the overvoltage detecting section 5N disposed at the last stage includes a photocoupler 7.

An LED of the photocoupler 7 is connected to a collector of the first transistor TR1 of the overvoltage detecting section 5N via a resistor. A phototransistor of the photocoupler 7 is electrically connected to a power supply VCC and a control portion of an external control substrate of the energy storage module 1 via a connector and a cable.

The comparator 6 and the first transistor TR1 of the overvoltage detecting section 5 are supplied with a terminal voltage of the capacitor Cy of the operating voltage generating portion 4 (for example, DC 5 V) as the operating voltage. The comparator 6 includes voltage comparing means (comparator), reference voltage generating means (for example, a diode), and an FET. In addition, the comparator 6 monitors the interterminal voltage of the storage cell C2 and compares the interterminal voltage with a predetermined reference voltage of approximately 3 V.

When the interterminal voltage of the storage cell C2 is the reference voltage or lower, the comparator 6 keeps the FET in an OFF state. Thus, each of TR1 and TR2 maintains an ON state by the current from the operating voltage generating portion 4. When none of the plurality of overvoltage detecting sections 5A to 5N detects an overvoltage of the storage cell C2, a current flows in the anode of the LED of the photocoupler 7 so that the LED emits light. Accordingly, the phototransistor of the photocoupler 7 becomes an ON state. As a result, an ON-signal indicating that all storage cells C2 are normal is sent to the control portion from the phototransistor of the photocoupler 7.

On the other hand, when the interterminal voltage of any one of the storage cells C2 exceeds the reference voltage, the comparator 6 of the overvoltage detecting section 5 connected to the storage cell C2 switches the FET from an OFF state to an ON state. Thus, a current flowing in a base of the TR2 is bypassed to the FET so that the TR2 becomes an OFF state and the TR1 also becomes an OFF state. Then, a base current of the TR2 of the overvoltage detecting section 5 below the above-mentioned overvoltage detecting section 5 is cut off so that the TR2 becomes an OFF state, and the TR1 connected to the TR2 also becomes an OFF state.

Then, the TR1 of the lowermost overvoltage detecting section 5N finally becomes an OFF state, and hence a current does not flow to the LED of the photocoupler 7 so that light emission of the LED is stopped. Accordingly, the phototransistor of the photocoupler 7 becomes an OFF state so that an output of the ON-signal from the phototransistor of the photocoupler 7 is stopped. In other words, the phototransistor of the photocoupler 7 outputs an OFF-signal.

In this way, the overvoltage detecting section 5 can detect the overvoltage of the storage cell C2 by the configuration in which the photocoupler 7 is conductive in the normal state and is nonconductive in the abnormal state. Note that, when the ON-signal from the phototransistor of the photocoupler 7 is stopped, namely, when the phototransistor outputs the OFF-signal, the control portion determines that an overvoltage is applied to any one of the storage cells C2 and sends an instruction to the charge and discharge unit so as to stop the charge and discharge of the energy storage unit 2.

According to the first embodiment as described above, the overvoltage detecting section 5 monitors the interterminal voltage of the storage cell C2, outputs the ON-signal indicating that the storage cell C2 is normal when the interterminal voltage is the reference voltage or lower, and outputs the OFF-signal when the interterminal voltage of the storage cell C2 exceeds the reference voltage. With this configuration, when there occurs a malfunction in wirings such as breaking of wire or removal of a connector of the energy storage module 1, or when there occurs a malfunction in an element of the overvoltage detecting section 5, the overvoltage detecting section 5 outputs the OFF-signal so that the control portion can detect such malfunctions. Thus, the reliability can be further improved. In addition, because the overvoltage detecting section 5 operates with the power from the external power supply 100, the overvoltage detecting section 5 can detect the overvoltage of the storage cell C2 stably regardless of the interterminal voltage of the storage cell C2.

In addition, the first capacitor Cx is level-shifted by sequentially adding potential differences of the negative electrode of the storage cell C2 in the same connection system as the first capacitor Cx and the negative electrode of the storage cell C2N to the rectangular wave voltage with reference to the connection node between the negative electrode of the storage cell C2N and the rectangular wave oscillating portion 3. With this configuration, the overvoltage detecting section 5 can be stably supplied with power without being affected by the interterminal voltage of the storage cell C2.

Here, depending on an application of the energy storage module 1, a high voltage region of 100 V or higher and a low voltage region of approximately 5 V are present in the module, and hence a restriction may occur in a layout of components or in design of patterns of the circuit substrate. Concerning this, in the first embodiment, the first capacitor Cx separates the high voltage region having mainly a DC voltage component from the low voltage region having mainly an AC voltage component of the rectangular wave. With this configuration, electric components corresponding to the high voltage region can be concentrated and disposed in the module so that the circuit design can be facilitated. In addition, the circuit can be downsized. This is effective particularly in a configuration in which a large number (for example, 50 or more) of the storage cells C2 are used.

In addition, in the first embodiment, it is possible to apply a desired operating voltage to the overvoltage detecting section 5 from a switching power supply or the like instead of the rectangular wave oscillating portion 3 and the operating voltage generating portion 4. However, in the configuration in which a large number (for example, 50 or more) of the storage cells C2 are used, it is necessary to incorporate the switching power supply having the same number of windings as the storage cell C2 in the module. Therefore, it is assumed that a product size increases, and also manufacturing cost increases. Concerning this, in the first embodiment, because the operating voltage generating portion 4 is formed of relatively small and inexpensive electric components, the product size and the manufacturing cost can be suppressed within a practical range.

Note that, in the first embodiment, the number of the storage cells C2 can be appropriately selected in accordance with the electricity storage capacity or the application. In addition, in the first embodiment, it is possible to dispose the rectangular wave oscillating portion 3 outside of the energy storage module 1 (for example, on the power supply substrate).

Further, in the first embodiment, the rectangular wave oscillating portion 3 is used as the AC voltage source. However, this example is not a limitation. It is possible to use a sine wave oscillating portion as the AC voltage source. In other words, it is possible to use a sine wave voltage as the AC voltage.

In addition, in the first embodiment, the resistor R connected to the first capacitor Cx constitutes the serial connection unit. However, this configuration is not a limitation. It is possible to connect an inductor in series to the resistor R to make a serial connection unit. In this case, it is possible to round the shape of the rectangular wave so as to suppress a peak current at a rising edge of the rectangular wave.

Further, in the first embodiment, the photocoupler 7 is disposed only in the overvoltage detecting section 5 at the last stage. However, this example is not a limitation. It is possible to dispose the photocoupler in each of the plurality of overvoltage detecting sections 5A to 5N. Alternatively, it is possible to divide the plurality of overvoltage detecting sections 5A to 5N into a plurality of groups and to dispose the photocoupler in one of the overvoltage detecting sections 5 in the group. Thus, the storage cell C2 in which the overvoltage is generated or the group including the storage cell C2 in which the overvoltage is generated can be informed to the control portion.

In addition, in the first embodiment, it is possible to connect the cathode terminal of the first diode D1 to the resistor R (serial connection unit), to connect the anode terminal of the first diode D1 to the negative electrode of the second capacitor Cy, further to connect the anode terminal of the second diode D2 to the cathode terminal of the first diode D1, and to connect the cathode terminal of the second diode D2 to the positive electrode of the storage cell C2 and the positive electrode of the second capacitor C2. In this case, it is possible to support a configuration in which the power supply voltage is a negative voltage.

## Claims

1. An overvoltage detecting device for an energy storage module to be disposed in the energy storage module including a plurality of storage cells connected in series, each of which includes an electric double-layer capacitor or a lithium-ion capacitor,
the overvoltage detecting device comprising a plurality of overvoltage detecting sections, each of which is connected in parallel to each of the plurality of storage cells, is supplied with power from an external power supply, monitors an interterminal voltage of the each of the plurality of storage cells, outputs an ON signal for indicating that the each of the plurality of storage cells is normal when the interterminal voltage is a predetermined reference voltage or lower, and outputs an OFF signal when the interterminal voltage of the each of the plurality of storage cells exceeds the predetermined reference voltage.

2. An overvoltage detecting device for an energy storage module according to claim 1, further comprising a plurality of operating voltage generating portions for rectifying an AC voltage from the external power supply so as to apply the rectified AC voltage to each of the plurality of overvoltage detecting sections.

3. An overvoltage detecting device for an energy storage module according to claim 2, wherein:
the each of the plurality of storage cells includes a negative electrode and a positive electrode;
the external power supply includes an AC voltage source for generating the AC voltage; and
the each of the plurality of operating voltage generating portions includes:
a level-shift portion for level-shifting by sequentially adding potential differences of the plurality of storage cells to the AC voltage with reference to a connection node between the negative electrode of one of the plurality of storage cells and the AC voltage source;
a rectifying portion for rectifying the level-shifted AC voltage; and
a smoothing portion for smoothing the rectified AC voltage.

4. An overvoltage detecting device for an energy storage module according to claim 3, wherein the each of the plurality of operating voltage generating portions includes:
a first capacitor connected in series to the AC voltage source so as to constitute the level-shift portion;
a serial connection unit including a resistor connected in series to the first capacitor, or a resistor and an inductor which are connected in series to the first capacitor and are connected in series to each other;
a second capacitor including a negative electrode and a positive electrode so as to constitute the smoothing portion;
a first diode including an anode terminal connected to a terminal opposite to the first capacitor, out of two terminals of the serial connection unit, and a cathode terminal connected to the positive electrode of the second capacitor, so as to constitute the rectifying portion; and
a second diode including a cathode terminal connected to the anode terminal of the first diode, and an anode terminal connected to the negative electrode of one of the plurality of storage cells and the negative electrode of the second capacitor, so as to determine a level-shift amount.

5. An overvoltage detecting device for an energy storage module according to claim 3, wherein the each of the plurality of operating voltage generating portions includes:
a first capacitor connected in series to the AC voltage source so as to constitute the level-shift portion;
a serial connection unit including a resistor connected in series to the first capacitor, or a resistor and an inductor which are connected in series to the first capacitor and are connected in series to each other;
a second capacitor including a negative electrode and a positive electrode so as to constitute the smoothing portion;
a first diode including a cathode terminal connected to a terminal opposite to the first capacitor, out of two terminals of the serial connection unit, and an anode terminal connected to the negative electrode of the second capacitor, so as to constitute the rectifying portion; and
a second diode including an anode terminal connected to the cathode terminal of the first diode, and a cathode terminal connected to the positive electrode of one of the plurality of storage cells and the positive electrode of the second capacitor, so as to determine a level-shift amount.
